(19) Europäisches Patentamt
European Patent Office
Office européen des brevets

(11) **EP 3 871 275 B1**

(12) **FASCICULE DE BREVET EUROPEEN**

(45) Date de publication et mention de la délivrance du brevet:
**04.05.2022 Bulletin 2022/18**

(21) Numéro de dépôt: **19813118.7**

(22) Date de dépôt: **25.10.2019**

(51) Classification Internationale des Brevets (IPC):
**H01L 35/16** [(2006.01)]    **C01G 23/00** [(2006.01)]

(52) Classification Coopérative des Brevets (CPC):
**H01L 35/16; C01G 23/007**

(86) Numéro de dépôt international:
**PCT/FR2019/052552**

(87) Numéro de publication internationale:
**WO 2020/084269 (30.04.2020 Gazette 2020/18)**

(54) **PROCÉDÉ DE PRÉPARATION DE COUCHES MINCES DE TYPE SULFURE DE TITANE / AMINE ET COUCHES MINCES OBTENUES**

VERFAHREN ZUR HERSTELLUNG VON TITANSULFID/AMIN-DÜNNSCHICHTEN UND ERHALTENE DÜNNSCHICHTEN

METHOD FOR PREPARING TITANIUM SULFIDE/AMINE THIN FILMS AND THIN FILMS OBTAINED

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.10.2018 FR 1859913**

(43) Date de publication de la demande:
**01.09.2021 Bulletin 2021/35**

(73) Titulaire: **IMRA Europe SAS**
**06560 Valbonne (FR)**

(72) Inventeurs:
• **JACOB, Stéphane**
**06160 JUAN LES PINS (FR)**
• **DELATOUCHE, Bruno**
**06560 VALBONNE (FR)**
• **CHMIELOWSKI, Radoslaw**
**06250 MOUGINS (FR)**

(74) Mandataire: **Lefevre-Groboillot, David André**
**Cabinet Weinstein**
**176 avenue Charles de Gaulle**
**92200 Neuilly sur Seine (FR)**

(56) Documents cités:
**WO-A1-2018/054464**

• **RUOMING TIAN ET AL: "A solution-processed TiS 2 /organic hybrid superlattice film towards flexible thermoelectric devices", JOURNAL OF MATERIALS CHEMISTRY A, vol. 5, no. 2, 10 novembre 2016 (2016-11-10), pages 564-570, XP055571200, GB ISSN: 2050-7488, DOI: 10.1039/C6TA08838D cité dans la demande**
• **CHUNLEI WAN ET AL: "Intercalation: Building a Natural Superlattice for Better Thermoelectric Performance in Layered Chalcogenides", JOURNAL OF ELECTRONIC MATERIALS., vol. 40, no. 5, 1 mai 2011 (2011-05-01), pages 1271-1280, XP055594071, US ISSN: 0361-5235, DOI: 10.1007/s11664-011-1565-5**
• **TOMOHIRO AOKI ET AL: "Evaluation of layered TiS2-based thermoelectric elements fabricated by a centrifugal heating technique", CERAMIC SOCIETY OF JAPAN. JOURNAL, vol. 119, no. 1389, 1 janvier 2011 (2011-01-01), pages 382-385, XP055594085, Tokyo, JP ISSN: 1882-0743, DOI: 10.2109/jcersj2.119.382**
• **EDWARD E. ABBOTT ET AL: "Thermoelectric Properties of TiS2 type materials", MRS PROCEEDINGS, vol. 793, 1 janvier 2003 (2003-01-01), XP055594080, DOI: 10.1557/PROC-793-S8.30**

EP 3 871 275 B1

## Description

## Domaine de l'invention

L'invention s'inscrit dans le domaine des matériaux thermoélectriques, et plus particulièrement des matériaux thermoélectriques se présentant sous la forme de couches minces.

L'invention porte plus particulièrement sur un procédé de préparation de couches minces de type sulfure de titane/amine résultant d'une intercalation d'une couche d'amine entre deux couches de sulfure de titane en formant une alternance de couches d'amine et de sulfure de titane.

L'invention porte également sur les couches minces ainsi obtenues.

## Art antérieur

La publication Tian et al (A solution-processed TiS2/organic hybrid superlattice film towards flexible thermoelectric devices, Journal of Material Chemistry A, 2017, 5, 564-570) concerne la réalisation d'un thermoélectrique flexible par intercalation d'hexylamine entre des couches de sulfure de titane. Le procédé décrit dans cette publication consiste essentiellement à réaliser la synthèse de sulfure de titane, réaliser l'intercalation d'hexylamine par broyage des poudres dans un mortier, ajouter du N-méthylformamide, réaliser une sonication de l'ensemble, réaliser une centrifugation, récupérer le surnageant de la centrifugation pour réaliser un dépôt de couches minces puis un recuit à 130°C pendant 6 heures des couches minces obtenues. Le facteur de puissance des couches minces obtenues est de 210 $\mu$W.K$^{-2}$.m$^{-1}$ à température ambiante.

## Inconvénients de l'art antérieur

Certaines étapes du procédé de la publication Tian et al. précité ne sont pas décrites de façon suffisamment précise et explicite pour assurer la reproductibilité du procédé dans son ensemble. En outre, les performances thermoélectriques sont insuffisantes pour envisager l'utilisation des couches minces dans certaines applications, notamment dans les domaines de la génération d'électricité ou du refroidissement par effet Peltier pour les technologies dites portables (« wearable technologies »). De tels dispositifs thermoélectriques à couches minces sont aptes à convertir la chaleur produite par le corps humain en électricité et pourraient ainsi trouver application pour alimenter les dispositifs électroniques miniaturisés et les capteurs pour la surveillance médicale ou pour la détection des mouvements.

## Objectifs de l'invention

L'invention vise un procédé de préparation de couches minces de type sulfure de titane/amine et de couches minces permettant de pallier les inconvénients précités, et notamment, pour des couches minces de type sulfure de titane/hexylamine, de présenter un facteur de puissance significativement plus élevé que celui des couches minces de la publication Tian et al.

## Exposé de l'invention

À cet effet, le procédé de l'invention comprend au moins les étapes suivantes de :

- synthèse du sulfure de titane,
- intercalation d'une amine dans le sulfure de titane,
- ajout d'un solvant choisi parmi le N-méthylformamide et le N,N-diméthylformamide,
- sonication sous température contrôlée de l'ensemble formé par le sulfure de titane, l'amine et le solvant,
- gélification du mélange issu de la sonication,
- première centrifugation du mélange au moins partiellement gélifié à une vitesse comprise entre 500 et 1 500 tours/min,
- seconde centrifugation du surnageant de la première centrifugation à une vitesse supérieure à la vitesse de la première centrifugation,
- réalisation de couches minces sur substrat à partir des sédiments de la seconde centrifugation, et
- recuit des couches minces formées.

Le procédé de l'invention peut également comporter les caractéristiques optionnelles suivantes considérées isolément ou selon toutes les combinaisons techniques possibles :

- la seconde centrifugation est réalisée à une vitesse supérieure à 1 000 tours/min, la vitesse de première centrifugation étant inférieure ou égale à 1 000 tours/min.

- la seconde centrifugation est réalisée à une vitesse d'environ 9 000 tours/min.

- l'amine est une amine primaire.

- laquelle amine est l'hexylamine.

- le recuit est réalisé à une température inférieure à 130°C.

- le recuit est réalisé à une température d'environ 90°C, une pression de 1 bar pendant une durée d'environ 30 minutes.

- la température de sonication est inférieure à 30°C.

- la température de sonication est d'environ 5°C.

- la gélification est réalisée en maintenant le mélange issu de la sonication à la température de sonication pendant une durée supérieure à 1 heure.

- la durée de gélification est supérieure à 6 heures.

- la sonication est réalisée par une succession de cycles comportant chacun une alternance de période de sonication et d'arrêt de la sonication.

- l'intercalation de l'amine dans le sulfure de titane est réalisée par broyage des poudres de sulfure de titane avec les poudres d'amines dans un mortier.

L'invention porte en outre sur des couches minces de type sulfure de titane/hexylamine présentant un facteur de puissance supérieur à 500 $\mu$W.K$^{-2}$.m$^{-1}$, de préférence un facteur de puissance supérieure à 800 $\mu$W.K$^{-2}$.m$^{-1}$.

## Présentation des figures

D'autres caractéristiques et avantages de l'invention ressortiront clairement de la description qui en est donnée ci-dessous, à titre indicatif et nullement limitatif, en référence aux figures annexées parmi lesquelles :

- la figure 1 est un graphique comparant l'évolution du facteur de puissance selon la température de couches minces de type sulfure de titane/hexylamine préparées par un procédé impliquant une unique opération de centrifugation, par un procédé impliquant une troisième opération de centrifugation, et par le procédé de l'invention comportant des première et seconde opérations de centrifugation,

- la figure 2 est un graphique illustrant l'évolution du facteur de puissance selon la température de deux couches minces de type sulfure de titane/hexylamine préparées par le procédé de l'invention et respectivement conservés 4 jours et 19 jours,

- la figure 3 est un graphique illustrant l'évolution du facteur de puissance selon la température d'une couche mince de type sulfure de titane/hexylamine réalisée par le procédé de l'invention pour une durée de gélification de 6 heures,

- la figure 4 est un graphique illustrant l'évolution du facteur de puissance selon la température d'une couche mince de type sulfure de titane/undécylamine réalisée par le procédé de l'invention, et

- la figure 5 est un graphique de diffractométrie de rayons X caractérisant la couche mince de type sulfure de titane/hexylamine de l'invention préparée selon le procédé de l'invention.

## Description détaillée de l'invention

Il est précisé que les figures représentent essentiellement un mode de réalisation de l'objet de l'invention mais qu'il peut exister d'autres modes de réalisation qui répondent à la définition de l'invention.

L'effet thermoélectrique est un phénomène physique présent dans certains matériaux qui lie le flux de chaleur qui les traverse à la puissance électrique qui les parcourt. Les matériaux thermoélectriques ont ainsi la double capacité de générer une puissance électrique lorsqu'ils sont exposés à un gradient de température (effet Seebeck), et de générer un flux de chaleur lorsqu'un courant électrique leur est appliqué dans la masse (effet Peltier).

Un matériau thermoélectrique est caractérisé par sa figure de mérite zT qui s'exprime de la façon suivante :

$$ZT = \frac{S^2 \sigma T}{\kappa}$$

où S est le coefficient de Seebeck ($\mu$V.K$^{-1}$)

$\sigma$ est la conductivité électrique (S.m$^{-1}$)
k est la conductivité thermique (W.K$^{-1}$.m$^{-1}$)
T la température (K)

La figure de mérite zT peut également s'exprimer de la façon suivante :

$$zT = \frac{S^2 T}{\rho \, \kappa}$$

où p est la résistivité électrique (en $\Omega$.m)

Le facteur de mérite zT a été conçu pour comparer les performances des matériaux thermoélectriques utilisés dans le mode Peltier. Dans le cas de l'utilisation de matériaux thermoélectriques dans le mode Seebeck, c'est-à-dire pour la génération de puissance électrique à partir d'un gradient de température, les performances des matériaux électriques peuvent être illustrées par un facteur de puissance PF qui s'exprime de la façon suivante :

$$PF = S^2 . \, \sigma = S^2 . \rho^{-1}$$

Enfin, la conductivité thermique peut s'exprimer de la façon suivante :

$$\kappa = D.c_p.d$$

Où D est la diffusivité thermique (en mm$^2$.s$^{-1}$),

Cp est la capacité thermique (en J.g$^{-1}$.K$^{-1}$)

d est la densité (en g.cm$^{-3}$)

Dans les exemples ci-dessous, les performances des matériaux thermoélectriques de l'invention sont caractérisées par leur facteur de puissance PF.

Le procédé de préparation de couches minces de type sulfure de titane/amine présentant un facteur de puissance supérieur à 500 $\mu$W.K$^{-2}$.m$^{-1}$ présente les étapes essentielles suivantes : synthèse du sulfure de titane, intercalation d'une amine dans le sulfure de titane, ajout d'un solvant choisi parmi le N-méthylformamide et le N,N-diméthylformamide, sonication sous température contrôlée de l'ensemble formé par le sulfure de titane, l'amine et le solvant, gélification du mélange issu de la sonication, première centrifugation du mélange au moins partiellement gélifié à une vitesse comprise entre 500 et 1 500 tours/min, seconde centrifugation du surnageant de la première centrifugation à une vitesse supérieure à la vitesse de première centrifugation, de préférence inférieure à 20 000 tours/min, réalisation de couches minces sur substrat solide, par exemple en verre, ou flexible, par exemple un film polymère en polytéréphtalate d'éthylène (PET), à partir des sédiments de la seconde centrifugation, et recuit des couches minces formées.

Si certaines de ces étapes sont évoquées dans la publication précitée Tian et al., la principale différence, mais non unique, entre le procédé décrit dans cette publication et le procédé de l'invention réside dans la réalisation d'une seconde centrifugation dans le procédé de l'invention, et l'utilisation des sédiments de cette seconde centrifugation comme encre de dépôt pour la réalisation de couches minces. Cette seconde centrifugation permet notamment de réaliser le dépôt de couches minces avec un gel comportant moins de solvant, ce qui engendre une température de recuit inférieure et l'accroissement des propriétés thermoélectriques des couches minces obtenues.

Cette seconde centrifugation est réalisée à une vitesse supérieure à la vitesse de première centrifugation pour permettre le dépôt des sédiments contenus dans le surnageant de la première centrifugation. On comprend qu'une vitesse de seconde centrifugation inférieure ou égale à la vitesse de première centrifugation ne permettrait pas d'opérer à la récupération des sédiments dans un surnageant qui a préalablement subit la première centrifugation. De préférence, la vitesse de seconde centrifugation est inférieure à 20 000 tours/min, et plus préférentiellement supérieure à 1 000 tours/min, à condition dans ce dernier cas que la vitesse de centrifugation soit bien inférieure à 1 000 tours/min.

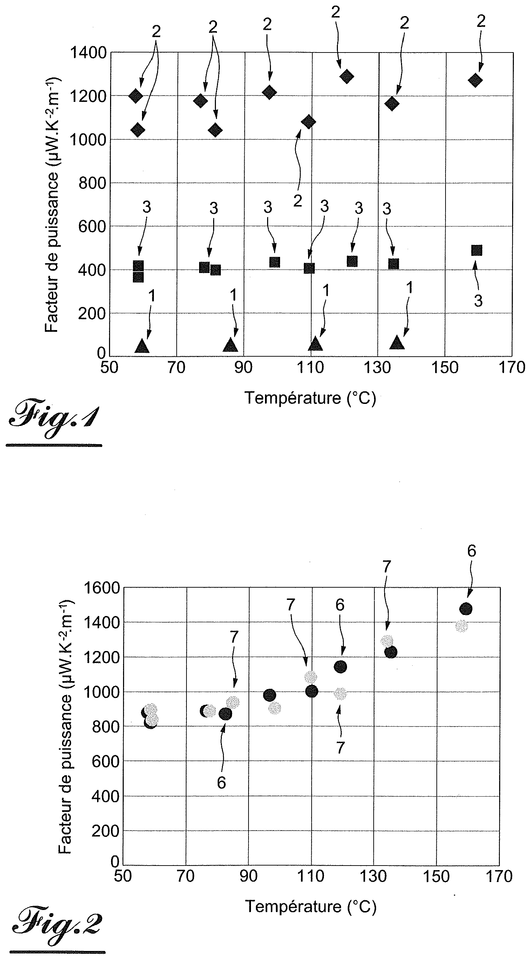

La figure 1 illustre le facteur de puissance selon la température de couches minces de sulfure de titane/hexylamine préparées selon différents procédés. Les références 1 se rapportent à un procédé en dehors de l'invention dans lequel une unique opération de centrifugation est réalisée à 1000 tours/min. Les références 2 se rapportent au procédé de l'invention pour lequel la vitesse de première centrifugation est de 1000 tours/min et la vitesse de seconde centrifugation est de 9 000 tours/min. Les références 3 se rapportent quant à elles à un procédé en dehors de l'invention pour lequel la vitesse de première centrifugation est de 1000 tours/min, la vitesse de deuxième centrifugation est de 9 000 tours/min, et une troisième opération de centrifugation à 18 000 tours/min est appliquée au surnageant de la seconde centrifugation.

On constate que l'application d'une unique opération de centrifugation (références 1) ne permet pas d'obtenir un facteur de puissance satisfaisant. On constate également que l'application d'une troisième opération de centrifugation au surnageant de la deuxième centrifugation (références 3). ne permet pas non plus, d'obtenir un facteur de puissance satisfaisant (environ 400 $\mu$W.K$^{-2}$.m$^{-1}$). Enfin, les résultats illustrés par les références 2 montrent que les sédiments de la seconde centrifugation opérée à une vitesse supérieure à la vitesse de première centrifugation permettent la réalisation de couches minces présentant, de façon inattendu, d'excellentes propriétés thermoélectriques supérieures à 1 000 $\mu$W.K$^{-2}$.m$^{-1}$.

En outre, la seconde centrifugation permet de procéder au dépôt de couches minces avec une encre gélifiée dont la teneur en solvant est faible. Le recuit après dépôt peut donc être réalisé à une température inférieure à 130°C, par exemple de 90°C pendant un temps court de 30 minutes comme il sera décrit plus loin dans l'exemple de préparation.

Comme évoqué plus haut, la réalisation d'une seconde centrifugation n'est pas le seul critère permettant de préparer des couches minces à propriétés thermoélectriques accrues. Notamment, l'étape de sonication est réalisée à température contrôlée et plus particulièrement sous refroidissement à une température inférieure à 30°C, par exemple de 5°C. Des tests réalisés par le déposant ont montré que la réalisation de l'étape de sonication à 30°C ne permet pas d'élaborer une quantité suffisante de matériau gélifié à déposer sur support.

La sonication est également réalisée sous flux d'azote par une succession de cycles comportant chacun une alternance de période de sonication et d'arrêt de la sonication, également couramment intitulés « cycles on/off ». Ces cycles on/off ne constituent pas en soi une caractéristique essentielle de l'invention sauf à considérer que la sonication doit être réalisée à puissance énergétique contrôlée (durée on, durée off, rapport on/off, température de sonication et/ou puissance de sonication ...)

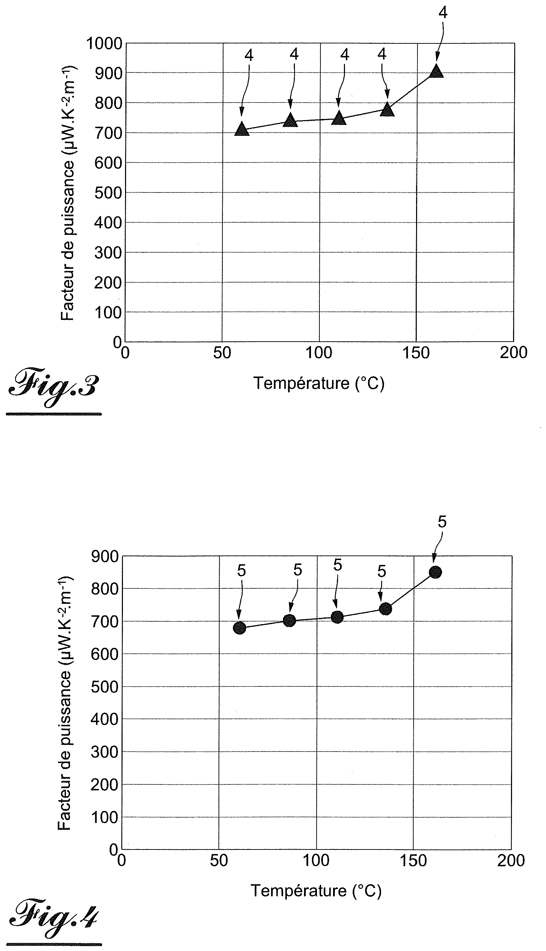

Le procédé de l'invention présente également une étape importante, il s'agit de la gélification après sonication. Il est connu que la gélification peut être réalisée de différentes manières, notamment par l'ajout de gélifiants. Pour ne pas atténuer les performances des couches minces de l'invention, la gélification du procédé de l'invention consiste préférentiellement à laisser reposer le mélange issu de la sonication avant de procéder à la première centrifugation, et de préférence à la même température que la température de gélification. Il a été constaté que la durée de gélification influe sur la quantité de matériau gélifié à déposer sur support. Pour une durée de 0 (c'est-à-dire une centrifugation immédiate du mélange issu de la sonication) on obtient quasiment aucun matériau gélifié à déposer sur support. En référence à la figure 3 (références 4) et en comparaison avec les références 2 de la figure 1, pour une durée de gélification de 6 heures (figure 3) comparée avec une durée de gélification de 11 heures (figure 1) et ce pour une vitesse de seconde centrifugation identique de 9 000 tours/min, on constate que le facteur de puissance augmente significativement avec la durée de gélification. Ainsi, pour une gélification consistant à laisser reposer le mélange issu de la sonication, la durée de gélification doit être supérieure à 1 heure, et de préférence supérieure à 6 heures.

L'amine utilisée dans le procédé de l'invention peut être tout type d'amine, par exemple une amine primaire telle que l'hexylamine ou l'undécylamine. La figure 4 (références 5) illustre les performances thermoélectriques obtenues avec de l'undécylamine pour une vitesse de seconde centrifugation de 9000 tours/min et une température de recuit de 110°C, l'échantillon ayant préalablement subi plusieurs cycles de chauffage et de refroidissement, et la figure 1 illustre les performances thermoélectriques obtenues avec de l'hexylamine pour une même vitesse de seconde centrifugation et une température de recuit de 90°C. On préfère l'hexylamine pour l'application d'une température de recuit inférieure et ses meilleures performances thermoélectriques.

Le solvant utilisé est un solvant choisi parmi le N-méthylformamide et le N,N-diméthylformamide mais peut être plus largement tout type de solvant polaire induisant la formation du gel.

Dans le procédé de l'invention, la synthèse de sulfure de titane est préférentiellement réalisée par chauffage des précurseurs dans une ampoule de quartz scellée sous vide et l'intercalation de l'amine dans le sulfure de titane est préférentiellement réalisée par broyage des poudres de sulfure de titane avec les poudres d'amines dans un mortier d'agate. Des tests réalisés à partir de poudre de sulfure de titane commercialisée (Aldrich, 333492, lot#MKBX0674V) ont montré un rendement moindre d'élaboration de l'encre que pour un sulfure de titane préparé tel que précédemment décrit.

La première centrifugation est réalisée à une vitesse comprise entre 500 et 1500 tours/min, de préférence à une vitesse de 1000 tours/min. Cette première centrifugation assure, par la récupération du surnageant, le retrait des sulfures de titanes non intercalés et/ou des grosses molécules de sulfures de titane.

Enfin, le dépôt de l'encre gélifiée sur support est réalisé par la méthode connue de type Doctor Blade consistant en un couteau mobile venant racler une solution déposée sur un substrat pour former une couche mince de solution (de gel dans l'invention) sur ledit substrat. En jouant sur la hauteur et la vitesse de passage du couteau, il est possible de contrôler l'épaisseur de la couche mince. Les couches minces de l'invention présentent à cet effet une épaisseur comprise entre 0,2 et 2 micromètre, de préférence entre 0,2 et 1 micromètre. Au-delà d'une épaisseur de 2 micromètres, il est observé une diminution sensible du facteur de puissance susceptible d'être expliquée par une possible dispersion des électrons aux interfaces des couches qui diminue leur mobilité et donc leur conductivité électronique.

Des tests de vieillissement ont été réalisés. En premier lieu, l'encre obtenue après la seconde centrifugation est laissée au repos pendant 6 heures, 30 heures et 50 heures avant d'être soumise au dépôt sur lames de verre. Il est constaté que les performances thermoélectriques ne sont pas modifiées à 6 heures de temps de repos, mais substantiellement diminuées à 30 et 50 heures (plus de 50% de diminution des performances thermoélectriques). Il est observé à cet effet une modification de la consistance de l'encre à environ 10 heures de repos. En second lieu, les couches obtenues après dépôt et chauffage sont conservées 4 jours et 19 jours après leur préparation. En référence à la figure 2 (références 6 pour une durée de conservation de 4 jours et références 7 pour une durée de conservation de 19 jours), il n'est pas constaté de diminution des performances thermoélectriques pour les couches conservées pendant 19 jours. Les couches minces obtenues par le procédé de l'invention présentent ainsi une bonne durée de conservation.

Enfin, les couches minces de type sulfure de titane/amine obtenues par le procédé de l'invention présentent un facteur de puissance supérieur à 500 $\mu W.K^{-2}.m^{-1}$ et de préférence supérieur à 800 $\mu W.K^{-2}.m^{-1}$. Le facteur de puissance est évalué à partir des mesures de la résistivité électrique et du coefficient Seebeck des couches minces en fonction de la température en utilisant un appareil connu pour la réalisation de telles mesures, par exemple le LSR-3 de la société Linseis. La couche mince déposée sur un substrat de verre est positionnée verticalement entre les électrodes respectivement supérieure et inférieure de l'appareil. Le contact entre la couche mince et l'appareil est assuré par des clips de platine maintenus par des pinces crocodiles, les clips assurant le contact avec les deux électrodes pour la mesure de la résistivité électrique. La différence de température et le voltage généré pour évaluer le coefficient de Seebeck sont mesurés au moyen de deux sondes dédiées dont l'extrémité libre est en contact surfacique avec la couche mince. Les mesures de la résistivité électrique et du coefficient Seebeck permettent d'évaluer le facteur de puissance selon la formule indiquée plus haut.

On décrit ci-après un exemple non limitatif de procédé de préparation de couches minces de type sulfure de titane/hexylamine.

Exemple de préparation de couches minces de sulfure de titane/hexylamine

La synthèse de sulfure de titane est réalisée par chauffage des précurseurs dans une ampoule de quartz scellée sous vide. L'intercalation est réalisée en mélangeant 1 mole de de $TiS_2$ pour 3 moles d'hexylamine dans un mortier d'agate. La pâte résultante est soumise à une sonication à 5°C dans du N-méthylformamide, la sonication étant réalisée par une succession de cycles on/off de 6 secondes « on » et 2 secondes « off » pour une durée totale « on » de 5 heures. Le mélange issu de la sonication est conservé à 5°C pendant 11 heures, puis centrifugé à une vitesse de 1000 tours/min pour retirer les grosses particules de $TiS_2$ ainsi que les particules non intercalées de $TiS_2$. Le surnageant de la première centrifugation est récupéré puis soumis à une seconde centrifugation à une vitesse de 9000 tours/min. Les sédiments de la seconde centrifugation sont récupérés pour former un encre à l'état de gel, puis déposés sur des lames de verre de 20 millimètres par 4 millimètres par la méthode Doctor Blade. Une couche d'une épaisseur comprise entre 0,2 et 1 millimètre est obtenu. Cette couche est ensuite séchée à 90°C à pression atmosphérique pendant 30 minutes. Les performances thermoélectriques de la couche obtenue sont référencées 2 sur la figure 1.

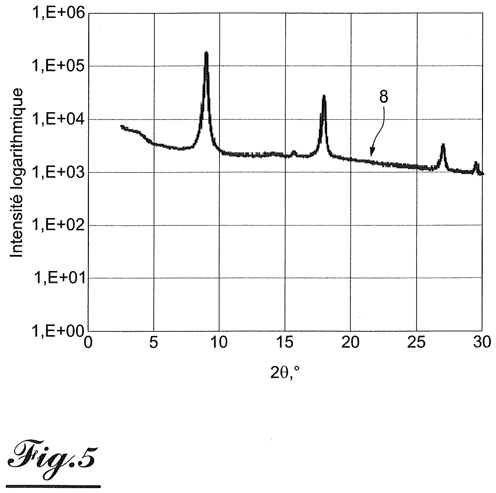

La couche mince obtenue est caractérisée par cristallographie aux rayons X (figure 5 référence 8). La faible largeur des pics illustre la bonne qualité de la cristallinité de la couche mince de l'invention. On constate par ailleurs la présence d'une phase unique dans la couche mince ce qui confirme la pureté cristalline de la couche mince de l'invention.

Le mode de réalisation décrit ci-dessus n'est nullement limitatif, et des modifications peuvent y être apportées sans sortir du cadre de l'invention.

Les applications des couches minces de l'invention formant un composé thermoélectrique sont nombreuses. On citera notamment les domaines de la génération d'électricité ou du refroidissement par effet Peltier pour les technologies dites portables (« wearable technologies ») ou encore, par la conversion de chaleur produite par le corps humain en électricité, pour alimenter les dispositifs électroniques miniaturisés et les capteurs pour la surveillance médicale ou pour la détection des mouvements.

**Revendications**

1. Procédé de préparation de couches minces de type sulfure de titane/amine comprenant au moins les étapes de :

   - synthèse du sulfure de titane,
   - intercalation d'une amine dans le sulfure de titane,
   - ajout d'un solvant choisi parmi le N-méthylformamide ou le N,N-diméthylformamide,
   - sonication sous température contrôlée de l'ensemble formé par le sulfure de titane, l'amine et le solvant,
   - gélification du mélange issu de la sonication,
   - première centrifugation du mélange au moins partiellement gélifié à une vitesse comprise entre 500 et 1 500 tours/min,
   - seconde centrifugation du surnageant de la première centrifugation à une vitesse supérieure à la vitesse de la première centrifugation,
   - réalisation de couches minces sur substrat à partir des sédiments de la seconde centrifugation, et
   - recuit des couches minces formées.

2. Procédé selon la revendication précédente, dans lequel la seconde centrifugation est réalisée à une vitesse supérieure à 1 000 tours/min, la vitesse de première centrifugation étant inférieure ou égale à 1 000 tours/min.

3. Procédé selon l'une quelconque des revendications précédentes dans lequel la seconde centrifugation est réalisé à une vitesse d'environ 9 000 tours/min.

4. Procédé selon l'une quelconque des revendications précédentes, dans lequel l'amine est une amine primaire.

5. Procédé selon la revendication précédente dans lequel l'amine est l'hexylamine.

6. Procédé selon la revendication précédente dans lequel le recuit est réalisé à une température inférieure à 130°C.

7. Procédé selon la revendication précédente dans lequel le recuit est réalisé à une température d'environ 90°C, une pression de 1 bar pendant une durée d'environ 30 minutes.

8. Procédé selon l'une quelconque des revendications précédentes, dans lequel la température de sonication est inférieure à 30°C.

9. Procédé selon la revendication précédente dans lequel la température de sonication est d'environ 5°C.

10. Procédé selon l'une quelconque des revendications précédentes, dans lequel la gélification est réalisée en maintenant le mélange issu de la sonication à la température de sonication pendant une durée supérieure à 1 heure.

11. Procédé selon la revendication précédente, dans lequel la durée de gélification est supérieure à 6 heures.

12. Procédé selon l'une quelconque des revendications précédentes dans lequel la sonication est réalisée par une succession de cycles comportant chacun une alternance de période de sonication et d'arrêt de la sonication.

13. Procédé selon l'une quelconque des revendications précédentes, dans lequel l'intercalation de l'amine dans le sulfure de titane est réalisée par broyage des poudres de sulfure de titane avec les poudres d'amines dans un mortier.

14. Couches minces de type sulfure de titane/hexylamine présentant un facteur de puissance supérieur à 500 $\mu$W.K$^{-2}$.m$^{-1}$.

15. Couches minces selon la revendication précédente, présentant un facteur de puissance supérieure à 800 $\mu$W.K$^{-2}$.m$^{-1}$.

**Patentansprüche**

1. Verfahren zur Herstellung von Titansulfid/Amin-Dünnschichten, umfassend mindestens die folgenden Schritte:

- Synthetisieren des Titansulfids,
- Einschieben eines Amins in das Titansulfid,
- Hinzufügen eines Lösemittels, ausgewählt aus dem N-Methylformamid oder dem N,N-Dimethylformamid,
- Beschallen unter kontrollierter Temperatur der Einheit, gebildet aus dem Titansulfid, dem Amin und dem Lösemittel,
- Gelieren der Mischung, die aus der Beschallung stammt,
- erstes Zentrifugieren der mindestens teilweise gelierten Mischung mit einer Geschwindigkeit, die zwischen 500 und 1500 Umdrehungen/Minute liegt,
- zweites Zentrifugieren des Überstands der ersten Zentrifugierung mit einer Geschwindigkeit über der Geschwindigkeit der ersten Zentrifugierung,
- Herstellen von Dünnschichten auf dem Substrat ausgehend von Sedimenten der zweiten Zentrifugierung, und
- Glühen der gebildeten Dünnschichten.

2. Verfahren nach dem vorhergehenden Anspruch, wobei das zweite Zentrifugieren mit einer Geschwindigkeit von mehr als 1000 Umdrehungen/Minute durchgeführt wird, wobei die Geschwindigkeit der ersten Zentrifugierung kleiner oder gleich 1000 Umdrehungen/Minute ist.

3. Verfahren nach einem der vorhergehenden Ansprüche, wobei das zweite Zentrifugieren mit einer Geschwindigkeit von mehr als 9000 Umdrehungen/Minute durchgeführt wird.

4. Verfahren nach einem der vorhergehenden Ansprüche, **dadurch gekennzeichnet, dass** das Amin ein primäres Amin ist.

5. Verfahren nach dem vorhergehenden Anspruch, wobei das Amin Hexylamin ist.

6. Verfahren nach dem vorhergehenden Anspruch, wobei das Glühen bei einer Temperatur von weniger als 130 °C durchgeführt wird.

7. Verfahren nach dem vorhergehenden Anspruch, wobei das Glühen bei einer Temperatur von ungefähr 90 °C, einem Druck von 1 Bar während einer Dauer von ungefähr 30 Minuten durchgeführt wird.

8. Verfahren nach einem der vorhergehenden Ansprüche, **dadurch gekennzeichnet, dass** die Beschallungstemperatur geringer als 30 °C ist.

9. Verfahren nach dem vorhergehenden Anspruch, wobei die Beschallungstemperatur ungefähr 5 °C ist.

10. Verfahren nach einem der vorhergehenden Ansprüche, wobei das Gelieren durchgeführt wird, indem die Mischung, die aus der Beschallung mit der Beschallungstemperatur stammt, während einer Dauer von mehr als 1 Stunde beibehalten wird.

11. Verfahren nach dem vorhergehenden Anspruch, wobei die Dauer des Gelierens mehr als 6 Stunden beträgt.

12. Verfahren nach einem der vorhergehenden Ansprüche, **dadurch gekennzeichnet, dass** das Beschallen durch eine Aufeinanderfolge von Zyklen durchgeführt wird, umfassend jeweils einen Wechsel zwischen Beschallungszeitraum und Stopp der Beschallung.

13. Verfahren nach einem der vorhergehenden Ansprüche, **dadurch gekennzeichnet, dass** das Einschieben des Amins in das Titansulfid durch Zerkleinern der Titansulfidpulver mit den Aminpulvern in einem Mörser durchgeführt wird.

14. Titansulfid/Hexylamin-Dünnschichten, die einen Leistungsfaktor von mehr als 500 $\mu$W.K$^{-2}$.m$^{-1}$. aufweisen.

15. Dünnschichten nach dem vorhergehenden Anspruch, die einen Leistungsfaktor von mehr als 800 $\mu$W.K$^{-2}$.m$^{-1}$ aufweisen.

## Claims

1. A method for preparing thin films of titanium sulfide/amine type comprising at least the steps of:

   - synthesizing titanium sulfide,
   - intercalating an amine in the titanium sulfide,
   - adding a solvent selected from among N-methylformamide or N,N-dimethylformamide,
   - under controlled temperature, sonicating the assembly formed by the titanium sulfide, amine and solvent,
   - gelling the mixture derived from sonication,
   - first centrifuging of the at least partially gelled mixture at a speed of between 500 and 1500 rpm,
   - second centrifuging of the supernatant from the first centrifugation at a speed greater than the speed of the first centrifugation,
   - forming thin films on a substrate from the sediments of the second centrifugation, and
   - annealing the formed thin films.

2. The method according to the preceding claim, wherein the second centrifugation is performed at a speed greater than 1000 rpm, the speed of the first centrifugation being less than or equal to 1000 rpm.

3. The method according to any of the preceding claims, wherein the second centrifugation is performed at a speed of about 9000 rpm.

4. The method according to any of the preceding claims, wherein the amine is a primary amine.

5. The method according to the preceding claim, wherein the amine is hexylamine.

6. The method according to the preceding claim, wherein annealing is performed at a temperature lower than 130 °C.

7. The method according to the preceding claim, wherein annealing is performed at a temperature of about 90 °C, at a pressure of 1 bar for a time of about 30 minutes.

8. The method according to any of the preceding claims, wherein the sonication temperature is lower than 30 °C.

9. The method according to the preceding claim, wherein the sonication temperature is about 5 °C.

10. The method according to any of the preceding claims, wherein gelling is obtained by holding the mixture derived from sonication at the sonication temperature for a time of longer than 1 hour.

11. The method according to the preceding claim, wherein the gelling time is more than 6 hours.

12. The method according to any of the preceding claims, wherein sonication is performed by a succession of cycles each comprising alternation of a sonication period and halting of sonication.

13. The method according to any of the preceding claims, wherein intercalation of the amine in the titanium sulfide is obtained by grinding titanium sulfide powders with the amine powders in a mortar.

14. Thin films of titanium sulfide/hexylamine type having a power factor higher than 500 $\mu W.K^{-2}.m^{-1}$.

15. The thin films according to the preceding claim having a power factor higher than 800 $\mu W.K^{-2}.m^{-1}$.

*Fig.1*

*Fig.2*

_Fig.3_

_Fig.4_

*Fig.5*

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **TIAN et al.** A solution-processed TiS2/organic hybrid superlattice film towards flexible thermoelectric devices. *Journal of Material Chemistry A,* 2017, vol. 5, 564-570